# EUROPÄISCHE PATENTSCHRIFT

(11) **EP 1 080 247 B1**
(45) Veröffentlichungstag und Bekanntmachung des Hinweises auf die Patenterteilung: **11.06.2003**
(21) Anmeldenummer: 99926265.2
(22) Anmeldetag: 15.04.1999
(51) Int. Cl.: C23C 28/02, H05K 3/02, H05K 3/10

(54) **VERFAHREN ZUM HERSTELLEN VON METALLISIERTEN SUBSTRATMATERIALIEN**
METHOD FOR PRODUCING METALLIZED SUBSTRATE MATERIALS
PROCEDE DE FABRICATION POUR MATERIAUX SUBSTRATS METALLISES

(30) Priorität: 20.04.1998 DE 19817388
(43) Veröffentlichungstag der Anmeldung: 07.03.2001
(73) Patentinhaber: ATOTECH Deutschland GmbH, 10553 Berlin (DE)
(72) Erfinder: MEYER, Heinrich, D-14109 Berlin (DE); SCHULZ, Ralf, D-16540 Hohen Neuendorf (DE); HEINZ, Roland, D-37154 Northeim (DE); KLUSMANN, Eckart, D-53840 Troisdorf (DE)
(74) Vertreter: Effert, Bressel und Kollegen
(86) Internationale Anmeldenummer: DE9901159
(87) Internationale Veröffentlichungsnummer: WO99054525

(56) Entgegenhaltungen:
- DE-A1- 3 512 196
- US-A- 3 294 059
- US-A- 4 717 587
- US-A- 4 990 363

## Beschreibung

Die Erfindung betrifft ein Verfahren zum Herstellen von metallisierten und zur Herstellung von im Gigahertzbereich (GHz) einsetzbaren elektrischen Schaltungsträgern geeigneten Substratmaterialien.

Zur Herstellung hochverdichteter elektrischer Schaltungen werden Schaltungsträger mit mehreren Leiterzugebenen verwendet. Diese Schaltungen dienen dazu, neben sogenannten passiven Bauelementen, beispielsweise Widerständen und Kondensatoren, auch aktive Bauelemente, d.h. integrierte Halbleiterschaltungen, zum Aufbau einer elektrischen Schaltung miteinander zu verbinden. In neuerer Zeit werden die aktiven Bauelemente auch ohne Gehäuse direkt auf die Schaltungsträger montiert, beispielsweise indem die Halbleiterschaltungen mit Bonddrähten direkt oder über sogenannte TAB-(tape automated bonding)-Verbinder auf die Anschlußplätze kontaktiert werden. Dadurch können höhere Leiterzugdichten erreicht werden als mit gehäusten Halbleiterschaltungen, da die Gehäuse einen erheblichen Platz auf den Schaltungsträgern beanspruchen, der für die Schaltung nicht genutzt werden kann.

Seit einiger Zeit werden derartige Schaltungsträger für neue Typen von Halbleiterbauelementen eingesetzt, beispielsweise von Multi-Chip-Modulen (MCM). Diese Bauelemente zeichnen sich durch eine höhere Funktionsdichte aus als herkömmliche aktive Bauelemente.

An die Techniken zur Herstellung der Schaltungsträger für diese Bauelemente werden immer höhere Anforderungen gestellt. Zum einen werden immer schmalere elektrische Leiterzüge in immer geringeren Abständen zueinander gebildet. Zum anderen werden auch Bauelemente für Anwendungen mit zunehmender thermischer Belastung wegen ansteigender Komplexizität der Verdrahtungsdichte gebraucht. Eine weitere Anforderung besteht darin, Bauelemente mit besonders hohen Schaltfrequenzen herzustellen. Die beispielsweise in Bürocomputern üblichen Taktfrequenzen liegen im Bereich von einigen hundert Megahertz (MHz). Es werden mittlerweile Taktfrequenzen in den Halbleiterschaltkreisen von über 1 GHz angestrebt, wobei die elektrischen Signale ohne nennenswerte Verluste und Verzerrung der Signalform übertragen werden sollen. Bei der Bewältigung der hierbei entstehenden Probleme spielen die Materialien für die Herstellung der Schaltungsträger eine wesentliche Rolle, da deren dielektrische Konstante ∈ und der dielektrische Verlustfaktor (tan δ) den ausnutzbaren Frequenzbereich überwiegend bestimmt.

Zur Herstellung der Schaltungsträger, beispielsweise von Multi-Chip-Modulen, werden unter anderem bekannte Herstellungsmethoden aus der Leiterplattentechnik eingesetzt. Beispielsweise können hierzu dielektrische Substrate aus Epoxidharzmaterial, das mit Glasfasermatten verstärkt ist, eingesetzt werden. An den Außenseiten dieser Laminate sind normalerweise Kupferschichten vorgesehen, aus denen die Leiterzüge durch Ätzen und gegebenenfalls durch elektrolytische Metallabscheideverfahren gebildet werden. Derartige Materialien sind ohne weiteres auch zur Herstellung mehrlagiger Schaltungsträger geeignet, indem mehrere mit einem Schaltungsmuster versehene Laminate miteinander verbunden werden.

Zur Herstellung besonders hochverdichteter Schaltungsmuster werden vorzugsweise ohne äußere Kupferschichten versehene dielektrische Substrate eingesetzt. Die für die Erzeugung der Leiterzüge benötigten Kupferschichten werden mit Metallisierungsverfahren auf die Laminate aufgebracht. Eine der möglichen Herstellmethoden besteht darin, Metallschichten durch Zersetzen flüchtiger Metallverbindungen in einer Glimmentladung zu bilden. Mit dieser Methode können auf den Substratoberflächen festhaftende Metallschichten gebildet werden.

Beispielsweise ist in DE 35 10 982 A1 ein Verfahren zum Herstellen von elektrisch leitenden Strukturen, z.B. Leiterbahnen, auf Nichtleitern beschrieben, bei dem ein metallischer Film durch Zersetzung metallorganischer Verbindungen in einer Glimmentladungszone abgeschieden wird. Als Nichtleiter werden Keramik, beispielsweise Aluminiumoxid- und Siliziumdioxidkeramiken, Glas, Kunststoffe, beispielsweise Polyimidfolie, und Verbundmaterialien genannt. Als zersetzbare Verbindungen werden organische Kupfer-, organische Zinn- und organische Palladiumverbindungen genannt. Die Verwendung von Nickeltetracarbonyl und Molybdänhexacarbonyl wird wegen der hohen Giftigkeit dieser Verbindungen als nicht einsetzbar bezeichnet.

Ferner ist in DE 38 06 587 A1 ein Verfahren zur Herstellung fest haftender metallischer Strukturen auf Polyimidoberflächen beschrieben. Dazu werden metallorganische Verbindungen in einer Glimmentladung unter Bildung eines metallischen Filmes gebildet. Es können Metalle der 1. und VIII. Nebengruppe des Periodensystems eingesetzt werden. Ausdrücklich werden Verbindungen von Palladium, Platin, Gold, Kupfer, Ruthenium und Iridium vorgeschlagen. Die Metallschichten, beispielsweise aus Palladium, werden anschließend mit weiteren Metallschichten überzogen, beispielsweise mit Kupfer oder Nickel, wobei diese weiteren Schichten in einem stromlosen Metallisierungsbad gebildet werden. Zur Verbesserung der Haftung der Metallschichten auf dem Dielektrikum wird dieses vor der Bildung der ersten Metallschichten mit geeigneten Plasmaprozessen gereinigt und angeätzt.

In DE 44 38 791 A1 ist ein weiteres Verfahren zur Abscheidung von Metallschichten auf Polyimidoberflächen beschrieben. Als in der Glimmentladungszone abscheidbare Metalle werden Palladium, Platin, Kupfer, Gold und Silber genannt. Im Gegensatz zu dem zuvor beschriebenen Verfahren werden weitere Metallschichten in einem sauer oder neutral eingestellten stromlosen Metallisierungsbad gebildet. Dadurch kann auf dem Polyimidmaterial auch während und nach einer thermischen Beanspruchung des Polymer/Metall-Verbundes noch eine ausreichend hohe Haftfestigkeit aufrechterhalten werden.

In WO 9612051 A1 ist ebenfalls ein Verfahren zur Abscheidung von Metallschichten auf Polyimidoberflächen beschrieben, bei dem die erste Metallschicht durch Zersetzung von flüchtigen Metallverbindungen mit einem Glimmentladungsverfahren erzeugt wird. Als abscheidbare Metalle werden insbesondere Palladium, Kupfer, Gold und Platin genannt sowie andere Metalle, die eine für die nachfolgende stromlose Metallabscheidung katalytische Metallschicht ausbilden können. Die Metallschichten werden hierbei in Gegenwart einer Gasmischung gebildet, die inerte Gase und Sauerstoff enthält. Dadurch wird das Problem gelöst, daß die gebildeten Metallschichten nach einer üblicherweise vorgenommenen Temperungsbehandlung zur Verfestigung der Schichten auf dem Substrat mit wäßrig-alkalischen Lösungen, beispielsweise einer Lösung zum Entwickeln von auf den Metallschichten aufgebrachten Photoresistschichten, in Kontakt gebracht wird. Bei den bis dahin bekannten Verfahren sank die Haftfestigkeit der Metallschichten bei einer derartigen Behandlung schlagartig auf sehr kleine Werte ab. Dabei lösten sich die Metallschichten von den Polyimidoberflächen in Einzelfällen vollständig ab.

Auch in dem wissenschaftlichen Artikel "Thin Palladium Films Prepared by Metal-Organic Plasma-Enhanced Chemical Vapour Deposition" in Thin Solid Films, Band 157 (1988), Seiten 81 bis 86, von E. Feurer und H. Suhr ist ein Verfahren zur Beschichtung von Polyimidoberflächen beschrieben. Zur Herstellung möglichst reiner Palladiumschichten wurden die Abscheidungs- und Nachbehandlungsbedingungen variiert. Eine Beschichtung in einem reinen Argonplasma führte zu mit Kohlenstoff verunreinigten Schichten. Durch nachfolgende Sauerstoffbehandlung im Plasma konnte eine bereits recht reine Palladiumschicht erhalten werden. Durch eine weitere Nachbehandlung in einem Wasserstoffplasma wurde der Metallgehalt der Schicht nicht wesentlich erhöht. Auf einem anderen Herstellungsweg durch Abscheidung aus einem Sauerstoffplasma konnte zwar eine von Kohlenstoff freie Schicht erhalten werden. Jedoch bestand die Schicht nun nicht aus Palladium sondern aus Palladiumoxid. Die Oxidschicht wurde durch nachfolgende Behandlung in einem Wasserstoffplasma zu reinem Palladium umgewandelt.

Es hat sich gezeigt, daß Polyimid gegenüber herkömmlichen Epoxidharzmaterialien, die üblicherweise für die Herstellung von Leiterplatten eingesetzt werden, zwar eine ausgezeichnete Wärmestabilität aufweist. Jedoch sind die dielektrischen Eigenschaften dieses Polymers (ε, tan δ) für manche Anwendungen nicht gut genug, so daß Hochfrequenzanwendungen im GHz-Bereich mit aus diesem Material hergestellten Schaltungsträgern nicht in jedem Fall realisiert werden können. Außerdem nimmt das Polymer durch die galvanotechnische Behandlung, bei der wäßrige Lösungen zum Beschichten verwendet werden, Wasser auf. Auch dadurch werden die dielektrischen Eigenschaften beeinträchtigt. Die Wasseraufnahme ist bei Verwendung von alkalischen Lösungen besonders stark ausgeprägt. Außerdem kann sich unter Umständen auch kein ausreichend haftfester Verbund zwischen den Metallschichten und dem Grundmaterial ausbilden.

Aus diesem Grunde wurden auch Versuche unternommen, besser geeignete Materialien für die Herstellung von Hochleistungsschaltungsträgern haftfest mit Metall zu beschichten. In DE P 37 44 062 A1 ist ein Verfahren zur Beschichtung von Fluoropolymeren offenbart. Auch in diesem Fall wird das Grundmaterial zuerst in einer Glimmentladungszone gereinigt und angeätzt und anschließend eine erste Metallschicht durch Zersetzung metallorganischer Verbindungen, beispielsweise von Palladium-, Platin-, Gold- und Kupferverbindungen, in einer Glimmentladungszone abgeschieden. Auf diese Metallschicht können wiederum weitere Metallschichten aus einem stromlosen Kupfer- oder Nickelbad niedergeschlagen werden.

Die bekannten Verfahren zur Bildung festhaftender und ausreichend dicker Metallschichten auf Polymerträgermaterialien gehen davon aus, eine erste Metallschicht in der Glimmentladungszone zu bilden und darauf eine zweite Metallschicht galvanotechnisch zu erzeugen, wobei in der Regel ein stromloses Beschichtungsverfahren bevorzugt wird, um keinen Beschränkungen bezüglich der für die elektrolytische Metallabscheidung erforderlichen hohen elektrischen Leitfähigkeit der mit einem Glimmentladungsverfahren erzeugten ersten Metallschicht unterworfen zu sein. Für die elektrolytische Metallabscheidung müßten nämlich relativ dicke erste Metallschichten in der Glimmentladung gebildet werden, beispielsweise 0,5 µm bis 1 µm dicke Schichten. Hierzu müßte eine lange Beschichtungszeit vorgesehen werden, so daß das Verfahren wegen der hohen Investitionskosten für die Beschichtungsanlage zu teuer werden würde. Aus diesem Grunde muß die erste Metallschicht für die nachfolgende stromlose Beschichtung katalytische Eigenschaften aufweisen. Hierauf wird auch bereits in WO 9612051 A1 hingewiesen. Für eine katalytisch wirksame Beschichtung werden üblicherweise Edelmetalle, wie Palladium, Platin, Gold und Kupfer, eingesetzt.

Es hat sich ferner herausgestellt, daß mit den bekannten Verfahren, bei denen das polymere Grundmaterial zum Erreichen einer ausreichenden Haftfestigkeit immer zuerst in einem Reinigungs- und Ätzverfahren vorbehandelt werden muß, um eine ausreichende Reinigung der Oberfläche und Haftfestigkeit des aufgebrachten Metallfilmes zu erreichen, für Hochfrequenzanwendungen im GHz-Bereich nicht geeignet ist. Die erhaltenen elektrischen Charakteristika der mit diesen Verfahren herstellbaren Schaltungsträger genügten in meisten Fällen nicht den Anforderungen.

Beispielsweise wird in der DE 37 44 062 A1 angegeben, daß die Vorbehandlung zur Reinigung und zum Anätzen der Oberflächen mit einem Plasma-Ätzprozeß durchgeführt wird. Vorzugsweise werden dem inerten Trägergas hierzu reaktive Gase, beispielsweise Sauerstoff oder Tetrafluormethan-Sauerstoff, zugesetzt. Nach einem Beispiel kann eine Mischung von Tetrafluormethan/Sauerstoff im Verhältnis von 1/3,5 verwendet werden. Es hat sich aber herausgestellt, daß die mit diesem Ätzprozeß erhaltenen Oberflächen sehr rauh sind. Die Mittenrauhwerte Rₐ liegen im µm-Bereich. Damit sind Metallisierungen auf derartigen Oberflächen nicht für die Herstellung von Schaltungsträgern für einen Einsatz im GHz-Bereich geeignet.

Das der vorliegenden Erfindung zugrunde liegende Problem besteht von daher darin, die Nachteile der bekannten Verfahren zu vermeiden und insbesondere haftfest mit Metall beschichtete Trägermaterialien für die Herstellung von Schaltungsträgern bereitzustellen, die für Hochfrequenzanwendungen im GHz-Bereich geeignet sind.

Das Problem wird gelöst durch das Verfahren gemäß Anspruch 1. Bevorzugte Ausführungsformen der Erfindung sind in den Unteransprüchen beschrieben. Bevorzugte Anwendungen des Verfahrens sind in den Ansprüchen 10 und 11 angegeben.

Zur Lösung des Problems werden Fluoropolymere als Trägermaterialien eingesetzt. Beispielsweise ist Polytetrafluorethylen (PTFE) für derartige Anwendungen besonders gut geeignet, da es eine sehr niedrige Dielektrizitätskonstante aufweist (ε = 2,1 bei 10⁸ Hz, 22°C).

Um die vorteilhaften Eigenschaften dieses Materials auszunutzen, hat es sich als unabdingbar herausgestellt, glatte Oberflächen des Materials haftfest zu beschichten. Zu starkes Aufrauhen beeinträchtigt dagegen die Signalübertragung und ist zudem für die Feinstleiteranwendungen ungeeignet.

Üblicherweise sind glatte Oberflächen zwar weniger gut geeignet, um darauf haftfest Metalle abzuscheiden. Beispielsweise können haftfeste Metallschichten durch eine zuerst niedergeschlagene Palladiumschicht mit dem Glimmentladungsverfahren auf derart glatten dielektrischen Oberflächen und ein nachfolgendes Überziehen dieser Schicht mit einer Kupferschicht mit einem stromlosen Metallisierungsverfahren nicht gebildet werden. Dies gelingt bei Anwendung bekannter Verfahren nur, wenn stark aufgerauht wurde. Im allgemeinen bilden Fluoropolymere mit anderen Stoffen nämlich nur äußerst schwache Wechselwirkungen aus, so daß eine Haftfestigkeit aufgebrachter Metallschichten bisher nur durch eine ausreichende Aufrauhung des Fluoropolymeren gelang. Der Haftungsmechanismus wird in diesem Fall üblicherweise im Sinne einer "Verkrallung" der Metallschicht im Grundmaterial verstanden.

Überraschenderweise wurde aber festgestellt, daß die gewünschten glatten Oberflächen dann haftfest beschichtet werden können, wenn anstelle der Edelmetallschichten erfindungsgemäß eine erste Nickel enthaltende Metallschicht auf den Fluoropolymeroberflächen durch Zersetzen flüchtiger Nickelverbindungen mit dem Glimmentladungsverfahren gebildet und nachfolgend eine zweite Metallschicht auf der Nickelschicht aus einem Metallisierungsbad abgeschieden wurde. Der Polymer/Metall-Verbund wies in diesem Falle eine hervorragende Haftfestigkeit auf, wobei die Eigenschaften der erzeugten Metallschichten auch für Hochfrequenzanwendungen im GHz-Bereich sehr gut waren. Selbstverständlich können haftfeste Metallschichten mit dem erfindungsgemäßen Verfahren auch auf Fluoropolymeren erzeugt werden, die durch vorangehende Reinigungs- und Ätzverfahren stärker aufgerauht wurden. Im Gegensatz zu den bekannten Verfahren ist diese Aufrauhung jedoch nicht zwingendes Erfordernis für eine ausreichende Haftfestigkeit der Metallschichten auf dem Polymeren und zudem nachteilig für die stromleitenden Eigenschaften metallisierter Fluoropolymere bei Höchstfrequenzanwendungen.

Neben Polytetrafluorethylen können auch andere Fluoropolymere eingesetzt werden, die eine niedrige Dielektrizitätskonstante aufweisen, beispielsweise Polychlortrifluorethylen (ε = 2,36 bei 10⁸ Hz, 25°C) oder fluoriertes Polyethylenpropylen (ε = 2,0 bei 10² bis 10⁶ Hz, 25°C).

Um möglichst reine Metallschichten bei der Durchführung des Glimmentladungsverfahren zu bilden, werden die Schichten nach deren Bildung vorzugsweise ebenfalls unter Einwirkung einer Glimmentladung nachbehandelt: Zuerst wird die Metallschicht in einer Sauerstoff enthaltenden Atmosphäre nachoxidiert. Dabei werden während des Abscheidungsprozesses durch unvollständige Zersetzung von Kohlenstoff enthaltenden flüchtigen Nickelverbindungen in die Schicht gelangende Kohlenstoffverbindungen zu Kohlenoxidverbindungen, beispielsweise Kohlendioxid, umgewandelt und damit diese Verbindungen aus der Schicht ausgetrieben. Um dabei entstehende Nickeloxide wieder in Nickel umzuwandeln, werden die Metallschichten anschließend in einer Wasserstoff enthaltenden Atmosphäre reduziert.

Die zweite Metallschicht wird vorzugsweise auf stromlosem Wege abgeschieden. In einer anderen Ausführungsform kann die zweite Metallschicht zwar auch durch elektrolytische Metallabscheidung gebildet werden. Hierzu müssen jedoch dickere erste Metallschichten im Glimmentladungsverfahren erzeugt werden, da eine elektrolytische Beschichtung nur auf einer ausreichend elektrisch leitfähigen Metallschicht möglich ist.

Als zweite Metallschicht wird vorzugsweise wiederum eine Nickelschicht oder eine Legierungsschicht von Nickel mit Bor oder Phosphor abgeschieden. Selbstverständlich können auch andere Metalle abgeschieden werden, beispielsweise anstelle von Nickel auch Kupfer, Kobalt, Gold, Palladium, Platin, Zinn, Blei sowie Legierungen dieser Metalle untereinander oder mit anderen Elementen.

Vor der Metallabscheidung werden die Substrate vorzugsweise vorbehandelt. Beispielsweise können sie in einem Glimmentladungsverfahren gereinigt und angeätzt werden. Hierzu wird das Fluoropolymer-Laminat in den Plasmareaktor, beispielsweise einen Parallelplattenreaktor gebracht und zwischen den Elektroden plaziert. Anschließend wird der Reaktorraum evakuiert und zur Reinigung und Anätzung ein Ätzgas eingeführt. Als Reinigungs- und Ätzgas kann beispielsweise ein Sauerstoff/Tetrafluormethan-Gemisch verwendet werden. Alternativ können auch reine Edelgasatmosphären oder Sauerstoff eingesetzt werden. Der Druck des Ätzgases im Reaktorraum wird auf mindestens etwa 10 Pa eingestellt. Die obere Grenze ergibt sich aus Praktikabilitätsgründen zu etwa 1500 Pa, vorzugsweise etwa 300 Pa. Zur Reinigung und Anätzung wird dann die Glimmentladung beispielsweise durch Hochfrequenzentladung (13,56 MHz) gezündet. Die Leistung des Hochfrequenzgenerators wird beispielsweise auf 0,5 Watt/cm² Substratoberfläche eingestellt. Die Temperatur des Substrats liegt im allgemeinen oberhalb von Raumtemperatur und beträgt beispielsweise etwa 100°C. Die Vorbehandlungszeit beträgt von etwa 0,1 bis etwa 30 Minuten, vorzugsweise von etwa 6 bis etwa 10 Minuten.

Die Vorbehandlungsbedingungen werden so eingestellt, daß eine möglichst glatte Substratoberfläche erhalten wird. Der Mittenrauhwert Rₐ der Fluoropolymeroberflächen soll nach Durchführung der Vorbehandlung mit dem Glimmentladungsverfahren, gemittelt über 1 µm², höchstens 100 nm, vorzugsweise höchstens 20 nm, betragen. Der Mittenrauhwert Rₐ wird hierzu nach der Methode einer Deutschen Norm (DIN 4762/1E, ISO/DIS 4287/1) ermittelt.

Um derartig glatte Oberflächen zu erhalten, wird das Ätzgas während der Einwirkung auf die Oberflächen auf einen Druck von mindestens 20 Pa, vorzugsweise mindestens 50 Pa, eingestellt.

Es hat sich ferner überraschenderweise herausgestellt, daß mit einer Sauerstoff/Tetrafluormethan-Mischung sehr glatte Oberflächen erhalten werden können. Unter diesen Bedingungen steigt die Rauhtiefe Rₐ während des Ätzprozesses nicht an, sondern sinkt sogar. Dadurch ist gewährleistet, daß die für Hochfrequenzanwendungen geeigneten Oberflächeneigenschaften des Dielektrikums während des Ätzverfahrens nicht verloren gehen.

Nach Abschluß des Reinigungs- und Ätzverfahrens wird der Reaktor wieder evakuiert. Anschließend wird Metall auf den dielektrischen Oberflächen niedergeschlagen. Hierzu wird die flüchtige Nickelverbindung mit einem Trägergas in den Reaktorraum eingelassen.

Als flüchtige Nickelverbindungen werden vorzugsweise organische Nickelverbindungen eingesetzt, beispielsweise π-Allyl-π-cyclopentadienyl-Nickel, Bis-(π-methylcyclopentadienyl)-Nickel, Bis-(π-dimethylcyclopentadienyl)-Nickel, Bis-(π-pentamethylcyclopentadienyl)-Nickel, π-Methylcyclopentadienyl-π-cyclopentadienyl-Nickel und Bis-(n-cyclopentadienyl)-Nickel. Außerdem können auch Nickeltetracarbonyl und Bis-(triphenylphosphin)-dicarbonyl-Nickel eingesetzt werden. Die letztgenannten Verbindungen sind jedoch besonders giftig und daher weniger gut geeignet. Als Trägergase kommen beispielsweise Wasserstoff, Argon und Mischungen dieser Gase in Betracht.

Zur Nickelabscheidung wird ein Druck von etwa 10 Pa bis etwa 1500 Pa, vorzugsweise von etwa 50 bis etwa 300 Pa, im Reaktorraum eingestellt. Während der Metallabscheidung wird ständig ein Gasstrom der flüchtigen Verbindung in dem Trägergasstrom über die Substratoberfläche geführt. Hierzu wird der Trägergasstrom durch ein außerhalb des Reaktors angeordnetes Reservoir für die Nickelverbindung geleitet, so daß die Nickelverbindung verdampft und dadurch in den Gasstrom überführt wird. Zur Abscheidung wird die Glimmentladung zwischen den Reaktorelektroden gezündet. Es wird wiederum vorzugsweise eine Hochfrequenzentladung gebildet (z.B. 13,56 MHz). Die Leistung des Hochfrequenzgenerators wird beispielsweise auf Werte von etwa 0,1 bis etwa 0,3 Watt/cm² Substratoberfläche eingestellt. Die Temperatur des Substrats wird im allgemeinen auf Werte oberhalb von Raumtemperatur eingestellt, beispielsweise auf Werte um 100°C. Die Abscheidungszeit richtet sich nach der gewünschten Nickelschichtdicke. Üblicherweise wird eine Beschichtungszeit von etwa 0,2 bis etwa 15 Minuten und vorzugsweise von etwa 1 bis etwa 8 Minuten eingestellt. Die Dicke der erhaltenen Nickelschicht beträgt etwa 5 bis etwa 500 nm.

Nach Bildung der Nickelschicht wird vorzugsweise ein Nachbehandlungszyklus angeschlossen, mit dem die gebildete Nickel enthaltende Schicht zuerst nachoxidiert und dann reduziert wird. Hierzu wird nach Evakuation der Reaktorkammer Sauerstoff eingeleitet. Zur Oxidation der Kohlenstoffspezies in der Schicht wird wiederum die Glimmentladung gezündet. Anschließend wird Wasserstoff in den Reaktorraum eingeleitet und die gebildeten Nickeloxide in der Glimmentladung zu metallischem Nickel reduziert.

Danach können auf die gebildete erste Metallschicht mit üblichen galvanotechnischen Verfahren weitere Metallschichten aufgebracht werden. Vorzugsweise wird Nickel aus einem stromlosen Bad abgeschieden. Geeignet sind beispielsweise Vernickelungsbäder mit hypophosphoriger Säure oder mit deren Salzen sowie Bäder mit Boranen als Reduktionsmittel.

Für die Schichtbildung werden die folgenden stromlosen Nickelbäder bevorzugt eingesetzt:
1. Stromloses Nickelbad mit Hypophosphit als Reduktionsmittel zur Erzeugung von Nickel/Phosphor-Schichten:

| | |
|---|---|
| Nickelsulfat (NiSO₄ · 5 H₂O) | 25 bis 30 g/l |
| Natriumhypophosphit (NaH₂PO₂ · H₂O) | 30 g/l |
| Citronensäure | 2 g/l |
| Essigsäure | 5 g/l |
| Aminoessigsäure | 10 g/l |
| Blei (als Bleiacetat) | 2 mg/l |
| pH-Wert | 6,2 |
| Temperatur | 80 bis 84°C |

Die erhaltene Nickel/Phosphor-Schicht enthält etwa 4 Gew.-% Phosphor. Anstelle von Nickelsalzen können auch Kobaltsalze zur Abscheidung von Kobalt/Phosphorschichten oder eine Mischung von Nickel- mit Kobaltsalzen zur Abscheidung von Nickel/Kobalt/Phosphor-Schichten verwendet werden.
2. Stromlose Nickelbäder mit Dimethylaminoboran als Reduktionsmittel zur Erzeugung von Nickel/Bor-Schichten:

| | | |
|---|---|---|
| 2a. | Nickelsulfat (NiSO₄ · 5 H₂O) | 25 g/l |
| | Dimethylaminoboran | 4 g/l |
| | Natriumsuccinat | 25 g/l |
| | Natriumsulfat | 15 g/l |
| | pH-Wert | 5,0 |
| | Temperatur | 60°C |

| | | |
|---|---|---|
| 2b. | Nickelsulfat (NiSO₄ · 5 H₂O) | 40 g/l |
| | Dimethylaminoboran | 1 bis 6 g/l |
| | Natriumcitrat | 20 g/l |
| | Milchsäure (85 Gew.-%ig) | 10 g/l |
| | pH-Wert | 7,0 |
| | Temperatur | 40°C |

| | | |
|---|---|---|
| 2c. | Nickelsulfat (NiSO₄ · 5 H₂O) | 50 g/l |
| | Dimethylaminoboran | 2,5 g/l |
| | Natriumcitrat | 25 g/l |
| | Milchsäure (85 Gew.-%ig) | 25 g/l |
| | Thiodiglykolsäure | 1,5 mg/l |
| | pH-Wert | 6 bis 7 |
| | Temperatur | 40°C |

Es können auch Bäder mit Nickelchlorid oder Nickelacetat anstelle von Nickelsulfat verwendet werden. Als Reduktionsmittel ist auch Diethylaminoboran anstelle von Dimethylaminoboran geeignet.

Anstelle von Nickel können auch Kobalt, Kupfer oder andere Metalle in üblicher Weise abgeschieden werden. In einer weiteren Verfahrensvariante kann anstelle einer stromlos erzeugten Schicht auch eine elektrolytisch abgeschiedene Schicht gebildet werden. Auch hierzu werden übliche Abscheideverfahren, vorzugsweise für Nickel, eingesetzt. Auf die zweite Metallschicht können weitere Metallschichten aus stromlosen oder elektrolytischen Metallisierungsbädern niedergeschlagen werden.

Das beschriebene Verfahren eignet sich zum Bilden von Leiterstrukturen auf den Substratoberflächen. Hierzu können unterschiedliche strukturbildende Verfahrenstechniken angewendet werden. Die Leiterstrukturen können beispielsweise durch einen Ätzprozeß gebildet werden, indem auf die erhaltene Metallschicht ein geeigneter Ätzresist aufgebracht wird, beispielsweise eine Photoresistfolie, ein Photoresistlack oder ein Siebdrucklack. Nach der für Photoresiste erforderlichen Strukturierung durch Belichten und Entwickeln werden die freigelegten, nicht den späteren Leiterstrukturen zuzuordnenden Metallschichtbereiche durch Abätzen entfernt. Anschließend kann der Resist von dem gebildeten Schaltungsträger wieder abgelöst werden. Eine andere Verfahrensvariante besteht darin, die zu bildenden Leiterstrukturen vor der Metallschichtbildung durch Aufbringen und Strukturieren von Resistschichten zu erzeugen. Die Metallstrukturen entstehen in diesem Fall automatisch bei der Metallisierung. Nach Abschluß des Metallisierungsprozesses wird die Resistschicht entfernt, so daß allein die Leiterstrukturen an den nicht von Resist bedeckten Stellen zurückbleiben. Selbstverständlich können auch kombinierte Techniken eingesetzt werden, beispielsweise die sogenannte Semiadditivtechnik, bei der zuerst eine ganzflächige Metallschicht gebildet wird, auf die dann eine Resistschicht aufgebracht wird. Nach dem Strukturieren der Resistschicht durch Belichten und Entwickeln werden weitere Metallschichten an den freigelegten Stellen abgeschieden. Nach dem Entfernen des Resists werden die nicht den Leiterstrukturen entsprechenden Metallschichtbereiche der zuerst aufgebrachten Metallschicht durch Abätzen entfernt.

Das erfindungsgemäße Verfahren ist auch zur Bildung von Plasmaätzmasken geeignet. Diese werden beispielsweise auf bereits hergestellte Schaltungsträger aufgebracht, um mit deren Hilfe mit einem Glimmentladungsverfahren nachträglich Löcher in das Substrat ätzen zu können. Das Verfahren zur Herstellung dieser Masken entspricht dem zur Herstellung von Leiterstrukturen auf Schaltungsträgern. Die zu bildenden Löcher im Substratmaterial müssen in der erhaltenen Metallschicht ebenfalls als Löcher erscheinen, damit das Plasmaätzgas durch diese hindurchgreifen kann.

Zur Fertigstellung eines Schaltungsträgers können mehrere Schaltungsträgerebenen nach der vorgenannten Methode ein- oder beidseitig mit Leiterzugstrukturen versehen werden. Anschließend können mehrere dieser Schaltungsträgerebenen ganzflächig miteinander verschweißt werden (Laminationsprozeß). Auf den Außenflächen dieses Pakets können wiederum Leiterzugstrukturen erzeugt werden. Zur Verbindung mehrerer Leiterzugebenen in dem Stapel werden zuerst Löcher gebildet, die die einzelnen Metallstrukturen in den Einzellagen anschneiden. Hierzu werden beispielsweise auf den Außenseiten des Stapels geeignete Metallmasken nach dem vorgenannten Verfahren gebildet und durch die in diesen Masken enthaltenen Löcher hindurch Löcher in das Substrat geätzt, beispielsweise in einer Glimmentladung. Nachträglich können die erzeugten Lochwände mit galvanotechnischen Methoden mit Metall beschichtet werden, um die einzelnen Ebenen elektrisch miteinander zu verbinden.

Auf die Außenseiten der derart gebildeten Schaltungsträger können nunmehr aktive und passive Bauelemente mechanisch und elektrisch montiert werden.

Die Erfindung wird anhand der nachfolgenden Beispiele näher erläutert:

### Beispiel 1:

| | |
|---|---|
| Substratmaterial | Teflon® FEP (Firma DuPont de Nemours, Inc. USA), (Größe 40 cm x 40 cm x 50 µm) |
| Reaktor | Parallelplattenreaktor |
| Frequenz | 13,56 MHz |

| 1. Vorbehandlung: | |
|---|---|
| Gas | Sauerstoff (100 sccm¹⁾)/Tetrafluormethan (40 sccm) |
| Elektrodentemperatur | 25°C |
| Druck im Reaktor | 160 Pa |
| Leistungsdichte | 0,63 Watt/cm² |
| Behandlungsdauer | 8 min |

| | |
|---|---|
| ¹⁾ sccm: Standard-cm³ (Gasfluß, gemessen bei 25°C) | |

| 2. Abscheidung: | |
|---|---|
| Trägergas | Argon (15 sccm)/Wasserstoff (300 sccm) |
| Metallorganische Verbindung | π-Allyl-π-cyclopentadienyl-Nickel |
| Temperatur des Vorratsbehälters | 65°C |
| Elektrodentemperatur | 80°C |
| Druck im Reaktor | 160 Pa |
| Leistungsdichte | 0,26 Watt/cm² |
| Beschichtungsdauer | 10 min |

| 3. Oxidation: | |
|---|---|
| Gas | Sauerstoff (100 sccm) |
| Elektrodentemperatur | 80°C |
| Druck im Reaktor | 160 Pa |
| Leistungsdichte | 0,63 Watt/cm² |
| Behandlungsdauer | 4 min |

| 4. Reduktion: | |
|---|---|
| Gas | Wasserstoff (100 sccm) |
| Elektrodentemperatur | 80°C |
| Druck im Reaktor | 160 Pa |
| Leistungsdichte | 1,26 Watt/cm² |
| Behandlungsdauer | 6 min |

Die Teflon®-Folie wurde auf die untere Elektrode eines Parallelplattenreaktors gelegt. Der Reaktor wurde auf den angegebenen Druck evakuiert und das Plasma gezündet. Nach der Vorbehandlung wurde die Nickelverbindung in einem Verdampfer mit dem Trägergas bei Reaktorkammerdruck durchströmt, unmittelbar vor Eintritt in die Reaktorkammer mit dem Wasserstoffstrom vereinigt und in die Glimmentladungszone eingebracht. Innerhalb von 10 Minuten bildete sich auf der glatten Teflon®-Oberfläche ein porenfreier nickelhaltiger Film mit einer Dicke von 10 bis 50 nm. Anschließend wurde der Film noch unter vorstehend angegebenen Bedingungen oxidiert und danach reduziert.

Der erhaltene Film wurde in einem stromlosen Nickelbad mit der folgenden Zusammensetzung:

| | |
|---|---|
| Nickelsulfat (NiSO₄·6 H₂O) | 20 g/l |
| Dimethylaminoboran | 2 bis 3 g/l |
| Natriumsulfat | 2 g/l |
| Milchsäure (90 Gew.-%ig) | 20 g/l |
| pH-Wert | 5,3 bis 5,6 |

bei einer Badtemperatur von 55°C verstärkt und anschließend elektrolytisch verkupfert. Danach wurden Leiterzüge aus der erhaltenen Metallschicht mit aus der Leiterplattentechnik bekannten Strukturierungsverfahren gebildet.

### Beispiel 2:

| | |
|---|---|
| Substratmaterial | Teflon® FEP (Firma DuPont de Nemours, Inc., USA), (Größe 40 cm x 40 cm x 50 µm) |
| Reaktor | Parallelplattenreaktor |
| Frequenz | 13,56 MHz |

| 1. Vorbehandlung: | |
|---|---|
| Gas | Sauerstoff (100 sccm)/Tetrafluormethan (40 sccm) |
| Elektrodentemperatur | 25°C |
| Druck im Reaktor | 160 Pa |
| Leistungsdichte | 0,63 Watt/cm² |
| Behandlungsdauer | 8 min |

| 2. Abscheidung: | |
|---|---|
| Trägergas | Wasserstoff (100 sccm)/Argon (50 sccm) |
| Metallorganische Verbindung | Nickeltetracarbonyl (50 sccm) |
| Temperatur des Vorratsbehälters | 25°C |
| Elektrodentemperatur | 25°C |
| Druck im Reaktor | 160 Pa |
| Leistungsdichte | 0,13 Watt/cm² |
| Beschichtungsdauer | 10 min |

Eine Teflon®-Folie wurde auf die untere Elektrode des Reaktors gelegt. Der Reaktor wurde auf den angegebenen Druck evakuiert und dann das Plasma zur Vorbehandlung gezündet. Anschließend wurde das Vorbehandlungsgas aus der Reaktorkammer wieder entfernt, danach die Trägergasatmosphäre zur nachfolgenden Metallabscheidung bis zum gewünschten Druck eingelassen und erneut das Plasma gezündet. Die Nickelverbindung wurde in einen Vorlagekolben unter Normaldruck mit Trägergas durchströmt und über eine Drossel in die Glimmentladungszone eingebracht. Innerhalb von 10 min wurde auf der glatten Probenoberfläche ein porenfreier Nickel enthaltender Film mit einer Dicke von 30 bis 100 nm haftfest abgeschieden.

Danach wurde die Teflon®-Folie aus dem Reaktor entfernt und ein Photoresist auf die Metallschicht aufgebracht. Die Resistschicht wurde nach üblichen Verfahren durch Belichten und Entwickeln mit einem Muster strukturiert. Danach wurden die vom Resist freigelegten Bereiche geätzt, so daß die Metallschicht in diesen Bereichen entfernt wurde. Anschließend wurde die Resistschicht wieder entfernt.

### Beispiel 3:

| | |
|---|---|
| Substratmaterial | Teflon® FEP (Firma DuPont de Nemours, Inc., USA), (Größe 40 cm x 40 cm x 50 µm) |
| Reaktor | Parallelplattenreaktor |
| Frequenz | 13,56 MHz |

| 1. Vorbehandlung: | |
|---|---|
| Gas | Sauerstoff (100 sccm)/Tetrafluormethan (40 sccm) |
| Elektrodentemperatur | 100°C |
| Druck im Reaktor | 160 Pa |
| Leistungsdichte | 0,63 Watt/cm² |
| Behandlungsdauer | 8 min |

| 2. Abscheidung: | |
|---|---|
| Trägergas | Wasserstoff (100 sccm)/Argon (15 sccm) |
| Metallorganische Verbindung | Bis-(π-cyclopentadienyl)-Nickel (25 mg/min) |
| Temperatur des Vorratsbehälters | 90°C |
| Elektrodentemperatur | 100°C |
| Druck im Reaktor | 160 Pa |
| Leistungsdichte | 0,26 Watt/cm² |
| Beschichtungsdauer | 4 min |

| 3. Oxidation: | |
|---|---|
| Gas | Sauerstoff (100 sccm) |
| Elektrodentemperatur | 100°C |
| Druck im Reaktor | 160 Pa |
| Leistungsdichte | 0,63 Watt/cm² |
| Behandlungsdauer | 4 min |

| 4. Reduktion: | |
|---|---|
| Gas | Wasserstoff (100 sccm) |
| Elektrodentemperatur | 100°C |
| Druck im Reaktor | 160 Pa |
| Leistungsdichte | 1,26 Watt/cm² |
| Behandlungsdauer | 6 min |

Eine Teflon®-Folie wurde auf die untere Elektrode des Reaktors gelegt. Der Reaktor wurde auf den angegebenen Druck evakuiert und zur Vorbehandlung das Plasma gezündet. Zu anschließenden Metallabscheidung wurde die Nickelverbindung im Verdampfer mit dem Argon als Trägergas bei Reaktorkammerdruck überströmt, unmittelbar vor Eintritt in die Reaktorkammer mit dem Wasserstoffstrom vereinigt und in die Glimmentladungszone eingebracht. Auf der Probenoberfläche wurde ein Nickel enthaltender Film von 10 bis 50 nm Dicke abgeschieden, der anschließend unter den vorgenannten Bedingungen oxidiert und reduziert wurde.

Danach wurde die erhaltene Nickelschicht in einem handelsüblichen stromlosen Nickelbad verstärkt und anschließend elektrolytisch verkupfert. Zur Bildung von Leiterzugstrukturen wurden wieder bekannte Verfahren zur Strukturierung angewendet.

### Beispiel 4:

Es wurden folgende Grundmaterialien beschichtet:
4A) Novoflon, FEP-Folie ( Firma Nowofol Kunststoffprodukte GmbH & Co. KG, Siegsdorf, DE), 50 µm Dicke, transparent
4B) Teflon® FEP, 50 µm Dicke
4C) PTFE-Folie (Firma Norton Pampus GmbH, Willich, DE), 50 µm Dicke
4D) PTFE-Folie (Firma Norton Pampus GmbH, Willich, DE), einseitig geätzt, 50 µm Dicke

Die Folien waren jeweils 40 cm x 40 cm groß. Sie wurden ohne weitere Vorbehandlung folgendem vierstufigen Plasma-Prozeß unterworfen (Tabelle 1).

Bei dem jeweils eingesetzten Polymersubstrat handelte es sich entweder um unlaminierte oder laminierte Polymerfolien (Träger: kupferkaschierter FR4-Epoxykern von etwa 1 mm Dicke). Die Vorbehandlung des Polymers (Schritt 1) diente zur Anätzung der Polymeroberflächen. In einer 8 Minuten langen Ätzbehandlung in der Glimmentladung wurden die Oberflächen mehrere µm tief abgetragen. Hierbei verringerte sich die mittlere Rauhtiefe (Rₐ) der Oberfläche.

Dies wurde durch AFM (atomic force microscopy)-Messungen nachgewiesen (Tabelle 2). Hierzu wurde die Probe mit einer sehr feinen Spitze abgerastert und die Höhenauslenkung in Abhängigkeit vom jeweiligen Ort der Spitze nach DIN 4768/1 gemessen (Rₐ: Mittenrauhwert in [Nanometer]).

Die Metallabscheidung führte zu einem Film mit hohem Nickelanteil auf den Polymeroberflächen (Stufe 2). Dieser Film wurde in zwei anschließenden Prozeßschritten zunächst oxidiert (Stufe 3) und anschließend reduziert (Stufe 4). Hierbei entstanden katalytisch aktive Nickelspezies auf der Polymeroberfläche, die in einem stromlosen Nickelbad mit Boranverbindungen als Reduktionsmittel zur homogenen Abscheidung eines metallischen Nickel/Bor-Filmes führten (Badtemperatur: 50°C).

Die metallische Nickelschicht wies eine Dicke von etwa (200 ∓ 100) nm auf. Das Substrat wurde anschließend 24 Stunden lang bei 100°C getempert. Danach wurde eine 15 bis 20 µm dicke Kupferschicht elektrolytisch aufgebracht.

Unmittelbar nach der elektrolytischen Abscheidung wurde die Haftfestigkeit der Metallschicht gemessen. Die Haftung beim Schältest betrug bei den Versuchen 4A) und 4B) jeweils über 10 N/cm, ohne daß weitere Temperungsschritte erforderlich waren.

**Tabelle 1:**

| Vierstufen-Plasma-Prozeß: | | | | |
|---|---|---|---|---|
| | Stufe 1 | Stufe 2 | Stufe 3 | Stufe 4 |
| Prozeßschritt | Substratvorbehandlung | Metallabscheidung | Oxidation der Schicht | Reduktion der Schicht |
| Gas | O₂/CF₄ | H₂/Ar | O₂ | H₂ |
| Gasfluß | 100(O₂) | 100 (H₂) | 100 | 100 |
| [sccm/min] ¹) | 40 (CF₄) | 15 (Ar durch Verdampfer) | | |
| Menge Ni-Ver- | - | 200 | - | - |
| bindung | | (∼ 5 sccm/ | | |
| [mg/Zyklus] | | min)¹) | | |
| Leistung. [Watt] | 1000 | 300 | 1000 | 2000 |
| Druck [Pa] | 160 | 160 | 160 | 160 |
| Behandl.zeit [min] | 8 | 4 | 4 | 6 |
| Temperatur [°C] | | | | |
| Verdampfer: | 90 | 90 | 90 | 90 |
| Zuleitung: | 110 | 110 | 110 | 110 |
| Kammer: | 100 | 100 | 100 | 100 |

| | | | | |
|---|---|---|---|---|
| ¹) sccm: Standard-cm³ (Gasfluß, gemessen bei 25°C) | | | | |

**Tabelle 2:**

| Rauhtiefe der PTFE-Folie (Probe 4C) bei der CF₄-Behandlung | |
|---|---|
| Vorbehandlung [min] | Rₐ¹) [nm] |
| 0 | 4,7 |
| 2 | 4,5 |
| 4 | 3,0 |
| 8 | 1,7 |

| | |
|---|---|
| ¹) Rₐ in [nm] über 1 µm² gemittelt, jeweils errechnet nach der Methode nach DIN 4762/1E//ISO/DIS 4287/1 | |

## Patentansprüche

1. Verfahren zum Herstellen von metallisierten Substratmaterialien, die zur Herstellung von im Gigahertzbereich einsetzbaren elektrischen Schaltungsträgern geeignet sind, bei dem Fluoropolymeroberflächen mit einem Mitten-rauhwert Rₐ von höchstens 100 nm, gemittet über 1 µm², aufweisende Substrate mit Metallschichten haftfest überzogen werden, indem
a. eine erste Nickel enthaltende Metallschicht auf den Fluoropolymeroberflächen durch Zersetzen flüchtiger Nickelverbindungen mit einem Glimmentladungsverfahren abgeschieden wird und
b. eine zweite Metallschicht auf der ersten Metallschicht aus einem Metallisierungsbad abgeschieden wird.

2. Verfahren nach Anspruch 1, **dadurch gekennzeichnet, daß** die erste Metallschicht in folgenden Verfahrenstufen nachbehandelt wird:
a1. Behandeln der Metallschicht in einer Sauerstoff enthaltenden Atmosphäre mit einem Glimmentladungsverfahren,
a2. Behandeln der Metallschicht in einer Wasserstoff enthaltenden Atmosphäre mit einem Glimmentladungsverfahren.

3. Verfahren nach einem der vorstehenden Ansprüche, **dadurch gekennzeichnet, daß** die zweite Metallschicht auf stromlosem Wege abgeschieden wird.

4. Verfahren nach Anspruch 3, **dadurch gekennzeichnet, daß** als zweite Metallschicht eine Nickelschicht oder eine Legierungsschicht von Nickel mit Bor oder Phosphor abgeschieden wird.

5. Verfahren nach einem der vorstehenden Ansprüche, **dadurch gekennzeichnet, daß** als flüchtige Nickelverbindungen organische Nickelverbindungen verwendet werden.

6. Verfahren nach einem der vorstehenden Ansprüche, **dadurch gekennzeichnet, daß** die Fluoropolymeroberflächen vor der Bildung der ersten Metallschicht mit einem Glimmentladungsverfahren in Gegenwart eines Ätzgases derart vorbehandelt werden, daß die Oberflächen sehr glatt sind.

7. Verfahren nach Anspruch 6, **dadurch gekennzeichnet, daß** der Mittenrauhwert Rₐ der Fluoropolymeroberflächen nach Durchführung der Vorbehandlung mit dem Glimmentladungsverfahren höchstens 20 nm, gemittelt über 1 µm², beträgt.

8. Verfahren nach einem der Ansprüche 6 und 7, **dadurch gekennzeichnet, daß** das Ätzgas während der Einwirkung auf die Oberflächen auf einen Druck von mindestens 20 Pa, vorzugsweise mindestens 50 Pa, eingestellt wird.

9. Verfahren nach einem der Ansprüche 6 bis 8, **dadurch gekennzeichnet, daß** die Fluoropolymeroberflächen in Gegenwart einer Sauerstoff/Tetrafluormethan-Gasmischung als Ätzgas vorbehandelt wird.

10. Anwendung des Verfahrens nach einem der vorstehenden Ansprüche zum Bilden von Leiterstrukturen auf den Fluoropolymeroberflächen durch Strukturieren der erhaltenen Metallschichten mit geeigneten Ätzresisten und anschließendes Abätzen der nicht die Leiterstrukturen bildenden Metallschichtbereiche oder durch Strukturieren der Fluoropolymeroberflächen mit geeigneten Resisten und anschließendes Abscheiden von Metallschichten in den die Leiter-Strukturen bildenden Bereichen der Fluoropolymeroberflächen.

11. Anwendung des Verfahrens nach einem der Ansprüche 1 bis 9 zum Bilden einer Maske zum Plasmaätzen auf den Fluoropolymeroberflächen durch Strukturieren der erhaltenen Metallschichten mit geeigneten Ätzresisten und anschließendes Abätzen der nicht die Maske bildenden Metallschichtbereiche oder durch Strukturieren der Fluoropolymeroberflächen mit geeigneten Resisten und anschließendes Abscheiden von Metallschichten in den die Maske bildenden Bereichen der Fluoropolymeroberflächen.

## Claims

1. Method of producing metallised substrate materials, which are suitable for producing electrical circuit carriers usable within the gigahertz range, wherein substrates, having fluoropolymer surfaces with a mean peak-to-valley value Rₐ of 100 nm at most, averaged over 1 µm², are coated with metal layers in a strongly bonded manner by
a. a first nickel-containing metal layer, being deposited on the fluoropolymer surfaces with a glow-discharge process by decomposing volatile nickel compounds, and
b. a second metal layer, being deposited on the first metal layer from a metallising bath.

2. Method according to claim 1, **characterised in that** the first metal layer is subsequently treated in the following method steps:
a1. treating the metal layer in an oxygen-containing atmosphere with a glow-discharge process, and
a2. treating the metal layer in a hydrogen-containing atmosphere with a glow-discharge process.

3. Method according to one of the previous claims, **characterised in that** the second metal layer is deposited without the use of an electric current.

4. Method according to claim 3, **characterised in that** a nickel layer or an alloy layer of nickel with boron or phosphorus is deposited as the second metal layer.

5. , Method according to one of the previous claims, **characterised in that** organic nickel compounds are used as the volatile nickel compounds.

6. Method according to one of the previous claims, **characterised in that**, prior to the formation of the first metal layer, the fluoropolymer surfaces are pretreated with a glow-discharge process in the presence of an etching gas in such a manner that the surfaces are very smooth.

7. Method according to claim 6, **characterised in that** the mean peak-to-valley value Rₐ of the fluoropolymer surfaces is 20 nm at most, averaged over 1 µm², after the pretreatment has been accomplished with the glow-discharge process.

8. Method according to one of claims 6 and 7, **characterised in that** the etching gas is set to a pressure of at least 20 Pa, preferably at least 50 Pa, during the action on the surfaces.

9. Method according to one of claims 6 to 8, **characterised in that** the fluoropolymer surfaces are pretreated in the presence of an oxygen/tetrafluoromethane gas mixture as the etching gas.

10. Use of the method according to one of the previous claims for forming conductor structures on the fluoropolymer surfaces by structuring the obtained metal layers with suitable etch resists and subsequently etching-away the metal layer regions which do not form the conductor structures, or by structuring the fluoropolymer surfaces with suitable resists and subsequently depositing metal layers in the regions of the fluoropolymer surfaces forming the conductor structures.

11. Use of the method according to one of claims 1 to 9 for forming a mask for plasma-etching on the fluoropolymer surfaces by structuring the obtained metal layers with suitable etch resists and subsequently etching-away the metal layer regions which do not form the mask, or by structuring the fluoropolymer surfaces with suitable resists and subsequently depositing metal layers in the regions of the fluoropolymer surfaces forming the mask.

## Revendications

1. Procédé de fabrication pour matériaux substrats métallisés appropriés à la fabrication de supports de circuits électriques utilisables dans la zone des giga-hertz, où des substrats présentant de surfaces en fluoropolymère présentant une valeur de rugosité Rₐ d'une distance entre les extrêmes d'au maximum 100 nm centrée sur 1 µm², sont recouvertes de façon adhésive en
a. déposant une première couche métallique contenant du nickel sur les surfaces en fluoropolymère en décomposant des composés de nickel volatil avec un procédé d'effluve électrique et en
b. déposant une deuxième couche métallique depuis un bain de métallisation sur la première couche métallisée.

2. Procédé selon la revendication 1, **caractérisé en ce que** la première couche métallisée est traitée postérieurement par les étapes de procédé suivantes
a1. traitement de la couche métallique par un procédé d'effluve électrique en atmosphère contenant de l'oxygène,
a2. traitement de la couche métallique par un procédé d'effluve électrique en atmosphère contenant de l'hydrogène.

3. Procédé selon l'une quelconque des revendications précédentes, **caractérisé en ce que** la deuxième couche métallique est déposée sans l'utilisation de courant.

4. Procédé selon la revendication 3, **caractérisé en ce qu'**une couche de nickel ou une couche d'un alliage de nickel avec du bore ou du phosphore est déposée en tant que deuxième couche métallique.

5. Procédé selon l'une quelconque des revendications précédentes, **caractérisé en ce que** des composés de nickel organique sont utilisés pour les composés de nickel volatils.

6. Procédé selon l'une quelconque des revendications précédentes, **caractérisé en ce qu'**avant la formation de la première couche métallique, les surfaces en fluoropolymère sont traitées par un procédé d'effluve électrique en présence d'un gaz caustique de telle façon que les surfaces soient très lisses.

7. Procédé selon la revendication 6, **caractérisé en ce qu'**après avoir effectué le pré-traitement avec le procédé d'effluve électrique, la valeur de rugosité Rₐ d'une distance entre les extrêmes des surfaces en fluoropolymère s'élève au maximum à 20 nm centré sur un 1 µm².

8. Procédé selon l'une quelconque des revendications 6 ou 7, **caractérisé en ce que** le gaz caustique est réglé à une pression d'au moins 20 Pa, de préférence au moins 50 Pa pendant qu'il agit sur les surfaces.

9. Procédé selon l'une quelconque des revendications 6 à 8, **caractérisé en ce que** les surfaces en fluoropolymère sont pré-traitées en présence d'un mélange gazeux d'oxygène / tetrafluoromethane en tant que gaz caustique.

10. Utilisation du procédé selon l'une quelconque des revendications précédentes pour former des structures conductrices sur les surfaces en fluoropolymère en structurant les couches métalliques obtenues avec des matériaux résistant à l'attaque appropriés et ensuite en attaquant les zones de la couche métallique ne formant pas les structures conductrices ou en structurant les surfaces en fluoropolymère avec des matériaux résistant à l'attaque appropriés et en ensuite déposant des couches métalliques dans les zones des surfaces en fluoropolymère formant les structures conductrices.

11. Utilisation du procédé selon l'une quelconque des revendications 1 à 9 pour former un masque pour l'attaque au plasma sur les surfaces en fluoropolymère en structurant les couches métalliques obtenues avec des matériaux résistant à l'attaque appropriés et ensuite en attaquant les zones des couches métalliques ne formant pas le masque ou en structurant les surfaces en fluoropolymère avec des matériaux résistant à l'attaque appropriés et ensuite déposant des couches métalliques dans les zones des surfaces en fluoropolymère formant le masque.
